# EUROPEAN PATENT SPECIFICATION

(11) **EP 1 889 288 B1**
(45) Date of publication and mention of the grant of the patent: **22.05.2013**
(21) Application number: 06768758.2
(22) Date of filing: 05.06.2006
(51) Int. Cl.: H01L 21/66, G06K 9/03

(54) **METHOD AND APPARATUS FOR INSPECTING MARKING OF SEMICONDUCTOR PACKAGE**
VERFAHREN UND VORRICHTUNG ZUM UNTERSUCHEN VON MARKIERUNGEN EINER HALBLEITERKAPSELUNG
PROCEDE ET APPAREIL D'INSPECTION DU MARQUAGE D'EMBALLAGES DE SEMI-CONDUCTEURS

(30) Priority: 07.06.2005 KR 20050048579
(43) Date of publication of application: 20.02.2008
(73) Proprietor: Intekplus Co., Ltd, Daejeon 305-500 (KR)
(72) Inventor: KANG, Min-gu, Yuseong-gu, Daejeon 305-755 (KR); YOO, Seung-bong, Youseong-gu, Daejeon (KR); LEE, Hyo-joong, Gyeonggi-do 437-801 (KR); LIM, Ssang-gun, Seo-gu, Daejeon 302-741 (KR)
(74) Representative: Grünecker, Kinkeldey, Stockmair & Schwanhäusser
(86) International application number: PCT/KR2006/002150
(87) International publication number: WO 2006/132484

(56) References cited:
- KR-A- 19990 078 833
- KR-A- 20000 014 107
- KR-A- 20030 091 453
- US-A- 5 933 531
- US-A1- 2002 092 910
- US-A1- 2002 092 910
- US-A1- 2004 057 611

## Description

### BACKGROUND OF THE INVENTION

### Field of the Invention

The present invention relates to a method and apparatus for inspecting a marking on a semiconductor package, and more particularly to a method and apparatus for inspecting a marking of a semiconductor package, which can quickly carry out a marking inspection of a semiconductor package, and can increase the accuracy of the inspection.

### Description of the Related Art

As well known in the art, a semiconductor integrated circuit (IC) manufactured by assembling a variety of semiconductor products has been provided to users throughout the world.

Generally, a marking process has been carried out after a packaging process. The marking process indicates category-, product characteristics, or manufacturing company- information of a corresponding semiconductor package on the surface of the semiconductor package, such that a user can recognize product characteristics and usages of the semiconductor package by referring to the marking printed on the semiconductor package.

In the meantime, the appearance of the semiconductor package acting as a finished product, on which a plurality of semiconductor package products are assembled and the marking process is carried out, is firstly inspected to determine whether outer terminals (e.g., outer leads) and the marking of the product are defective, in such a way that a quality control process of the semiconductor package is carried out, and the resultant semiconductor package is finally placed on the market.

The above-mentioned semiconductor package may have a variety of defective markings.

For example, a desired character may not be printed on the semiconductor package, a desired character may be discontinuously printed on the semiconductor package, a wrong character may be printed on the semiconductor package, or a marking location of the character may escape from a normal range, in such a way that the marking process is abnormally carried out on the semiconductor package.

Also, although the marking process is normally carried out on the semiconductor package, different products may be unexpectedly mixed with each other. In this case, a variety of products having different characteristics and usages are mixed with each other, resulting in the occurrence of fatal inferiority.

Therefore, the marking inspection is carried out the semiconductor package before the semiconductor package finally comes into the market, such that it determines the presence or absence of either a defective marking product or the mixing of different products within a lot (i.e., a consignment unit).

A conventional marking inspection method captures a marking character of a first package of a new lot using a CCD camera to detect an image of the marking character, sets the detected marking-character image to a standard image, and matches patterns of the marking images of following packages with that of the standard image, such that it determines the presence or absence of a defective marking.

However, provided that the first package from among a plurality of packages to be inspected has a defective marking, the above-mentioned conventional marking inspection method inaccurately carries out the marking inspection of the remaining packages following the first package, such that it may erroneously recognize a normal package as a defective package, or may also erroneously recognize the defective package as the normal package.

A representative example for solving the above-mentioned erroneous marking inspection problems has been disclosed in Korean Patent Registration No. 10-0348102, entitled "METHOD FOR INSPECTING DEFECTIVE MARKING OF SEMICONDUCTOR PRODUCT BY RECOGNIZING OPTICAL CHARACTER", which is incorporated herein by reference.

The method for inspecting the defective marking of the semiconductor product via the optical character recognition according to the Korean Patent Registration No. 10-0348102, includes the steps of: a) entering, by an input unit, a marking character as a character string; b) storing, by a storage unit, the character string as a reference inspection value; c) providing a carry-in unit with at least one semiconductor product in lot units; d) recognizing the marking character of the semiconductor product provided to the carry-in unit as a character image using a camera; e) recognizing, by an optical character recognition unit, the recognized marking character as a character string; f) comparing the recognition result of the character string with a reference value of the character string, and determining whether the marking character is defective; and g) selectively providing a carry-out unit with a normal semiconductor product or a defective semiconductor product upon receiving a control signal from a controller according to the determined result.

However, the above-mentioned method for inspecting the defective marking of the semiconductor product via the optical character recognition according to the Korean Patent Registration No. 10-0348102 must firstly recognize character strings of all semiconductor package packages associated with the marking inspection using the optical character recognition unit, and must compare individual recognized character strings with the stored reference character string value, such that a long period of time is consumed to recognize individual characters of all the semiconductor packages, resulting in deterioration of inspection efficiency.

Other prior art documents teaching defective semiconductor product markings include US2002/092910, KR2000-0014107, both on the name of Samsung Electronics Ltd. These documents, however, do not teach updating the reference image information of a corresponding lot of semiconductor packages as in step (d) of claim 1 with the specific sequence defined by the sub-steps (d1)-(d6).

### SUMMARY OF THE INVENTION

Therefore, the present invention has been made in view of the above problems, and it is an object of the present invention to provide a method and apparatus for inspecting a marking on a semiconductor package, which acquires character string information from only a semiconductor package to be used as reference image information according to an optical character recognition method, determines the presence or absence of a defective marking in the semiconductor package according to the comparison result of the acquired character string information, and compares only image information of other semiconductor packages following the semiconductor package, such that it quickly executes a marking inspection and increases the accuracy of the inspection.

In accordance with one aspect of the present invention, the above and other objects can be accomplished by the provision of a method for inspecting a marking of a semiconductor package comprising the steps of: a) acquiring character string information of a semiconductor package of a target lot to be inspected, and storing the acquired character string information as reference character string information; b) capturing a character pattern printed on an incoming semiconductor package, and acquiring image information of the incoming semiconductor package; c) displaying the acquired image information to allow a user or operator to visually recognize the acquired image information; d) detecting character string information from the displayed image information according to a setup signal, comparing the detected character string information with the pre-stored character string information, and determining the displayed semiconductor-package image information to be reference image information of a corresponding lot when the detected character string information is equal to the pre-stored character string information; and e) comparing the determined reference image information with image information of sequentially-incoming semiconductor packages, and classifying a corresponding semiconductor package into a defective-package storage unit when the determined reference image information is different from the image information of the sequentially-incoming semiconductor packages.

Preferably, the step (d) for determining the reference image information includes the steps of: d1) determining the presence or absence of reference image information associated with the target lot to be inspected; d2) determining whether the setup signal is received; d3) if the absence of the reference image information is determined, acquiring character string information from the acquired image information according to the setup signal; d4) determining whether the acquired character string information is equal to the pre-stored reference character string information; d5) if the acquired character string information is equal to the pre-stored reference character string information, determining image information of a corresponding semiconductor package to be reference image information of a corresponding lot; and d6) if the acquired character string information is different from the pre-stored reference character string information, determining that the corresponding semiconductor package has a defective marking, and classifying the defective semiconductor package.

Preferably, the method further comprises the step of: after comparing the detected character string information with the pre-stored character string information at the step (d), if the detected character string information is different from the pre-stored character string information, generating a warning drive signal.

Preferably, the method further comprises the step of: after comparing the determined reference image information with the image information of the sequentially-incoming semiconductor packages at step (e), if the determined reference image information is different from the image information of the sequentially-incoming semiconductor packages, generating a warning drive signal.

Preferably, the character string information associated with the semiconductor package of the target lot to be inspected is acquired from a keyboard.

Preferably, the character string information associated with the semiconductor package of the target lot to be inspected is acquired from a reader for reading character strings recorded in a corresponding lot card.

Preferably, the method further comprises the steps of: upon receiving a command signal for changing the determined reference image information, detecting character string information from the displayed image information; and if the detected character string information is equal to the reference character string information, updating corresponding image information to the pre-stored reference image information, and storing the updated image information.

In accordance with another aspect of the present invention, there is provided an apparatus for inspecting a marking of a semiconductor package comprising: a camera module for capturing a character pattern of a semiconductor package via a lens; an input unit for entering reference character string information of a target lot to be inspected and a variety of operation signals; a memory for storing the reference character string information received from the input unit; a display for displaying the captured image acquired from the camera module; a controller for detecting character string information from the displayed image information upon receiving a setup signal from the input unit, determining whether the detected character string information is equal to the pre-stored reference character string information, storing corresponding image information in the memory as reference image information or generating a warning drive signal according to the determined result, if the reference image information is stored in the memory, comparing the reference image information with the image information received from the camera module, and if the reference image information is different from the image information received from the camera module, generating the warning drive signal, and generating a defective-package classification control signal for classifying a corresponding semiconductor package into the defective package; an alarm unit for generating an alarm signal upon receiving the warning drive signal from the controller; and a classification module for classifying the corresponding semiconductor package into a defective-package storage unit upon receiving the defective-package classification control signal from the controller.

Preferably, the controller may include: a character-string detector for detecting character string information from the displayed image information according to the setup signal; a character-string processor for comparing the detected character-string information with the reference character string information stored in the memory, storing the displayed image information as the reference image information in the memory if the detected character-string information is equal to the reference character string information, and generating a character-string error signal if the detected character-string information is different from the reference character string information; an image processor for comparing the reference image information stored in the memory with the image information received from the camera module, generating an image error signal if the reference image information is different from the received image information, and updating the reference image information stored in the memory upon receiving a signal for changing the reference image information; a warning drive controller for generating the warning drive signal to the alarm unit or the display according to the character-string error signal or the image error signal; and a classification drive controller for outputting a defective-package classification control signal capable of classifying a corresponding semiconductor package into the defective semiconductor package to the classification module according to the character-string error signal or the image error signal.

### BRIEF DESCRIPTION OF THE DRAWINGS

The above and other objects, features and other advantages of the present invention will be more clearly understood from the following detailed description taken in conjunction with the accompanying drawings, in which:
FIG. 1 is a block diagram illustrating an apparatus for inspecting a marking of a semiconductor package according to the present invention; and
FIG. 2 is a flow chart illustrating a method for inspecting a marking of a semiconductor package according to the present invention.

### DESCRIPTION OF THE PREFERRED EMBODIMENTS

Now, preferred embodiments of the present invention will be described in detail with reference to the annexed drawings. In the drawings, the same or similar elements are denoted by the same reference numerals even though they are depicted in different drawings. In the following description, a detailed description of known functions and configurations incorporated herein will be omitted when it may make the subject matter of the present invention rather unclear.

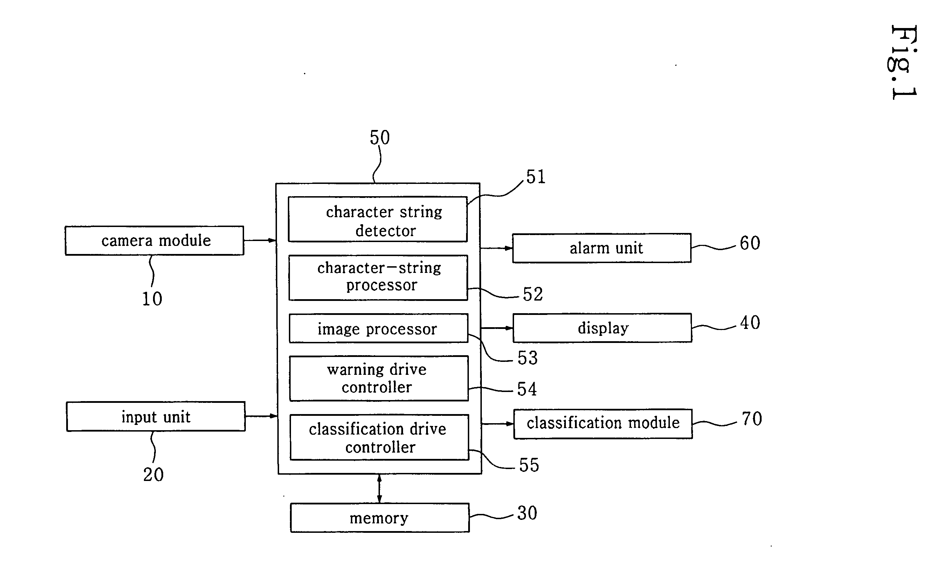

FIG. 1 is a block diagram illustrating an apparatus (also called a marking inspection device) for inspecting a marking of a semiconductor package according to the present invention.

Referring to FIG. 1, the above-mentioned marking inspection device of the semiconductor package according to the present invention includes a camera module 10, an input unit 20, a memory 30, a display 40, a controller 50, an alarm unit 60, and a classification module 70.

The camera module 10 captures a character pattern of a semiconductor package via a lens. The input unit 20 enters reference character string information of an object lot to be inspected and a variety of operation signals. The memory 30 stores the reference character string information received from the input unit 20. The display 40 displays the captured image received from the camera module 10.

The controller 50 detects character string information from the displayed image information upon receiving a setup signal from the input unit 20. The controller 50 determines whether the detected character string information is equal to the reference character string information, such that it stores corresponding image information in the memory 30 as the reference image information or generates a warning drive signal according to the determined result. If the reference image information is stored in the memory 30, the controller 50 compares the reference image information with the image information received from the camera module 10. If the reference image information is different from the image information received from the camera module 10, the controller 50 outputs the warning drive signal, and outputs a defective-package classification control signal for classifying a corresponding semiconductor package into the defective package.

The alarm unit 60 outputs an alarm signal upon receiving the warning drive signal from the controller 50. The classification module 70 classifies the corresponding semiconductor package into a defective-package storage unit upon receiving the defective-package classification control signal from the controller 50.

In order to capture a character on the semiconductor package and acquire image information of the captured character, the camera module 10 illuminates light on a target object to be inspected, and focuses the light reflected from the target object on a lens, such that it can acquire desired image information.

The input unit 20 may include a keyboard for allowing a user to directly enter the reference character string information; a reader of a lot card in which character string information associated with a semiconductor package of a lot of the target object is recorded; and a key input unit for entering a variety of operation signals.

The memory unit 30 stores the reference character string information received from the input unit 20 and the reference image information received from the controller 50.

The display 40 displays the semiconductor package image information acquired by a continuous-shooting operation of the camera module 10, provides a user or operator with the semiconductor package image information, and provides the user or operator with a defective marking message according to a character-string error signal or an image-information error signal.

The controller 50 includes a character-string detector 51, a character-string processor 52, an image processor 53, a warning drive controller 54, and a classification drive controller 55.

The character-string detector 51 detects character string information from the displayed image information according to the setup signal.

The character-string processor 52 compares the detected character-string information with the reference character string information stored in the memory 30, stores the displayed image information as the reference image information in the memory 30 if the detected character-string information is equal to the reference character string information, and outputs a character-string error signal if the detected character-string information is different from the reference character string information.

The image processor 53 compares the reference image information stored in the memory 30 with the image information received from the camera module 10, outputs an image error signal if the reference image information is different from the received image information, and updates the reference image information stored in the memory 30 upon receiving a signal for changing the reference image information.

The warning drive controller 54 outputs the warning drive signal to the alarm unit 60 or the display 40 according to the character-string error signal or the image error signal.

The classification drive controller 55 outputs a defective-package classification control signal for classifying a corresponding semiconductor package into the defective semiconductor package to the classification module 70 according to the character-string error signal or the image error signal.

The alarm unit 60 receives the warning drive signal from the warning drive controller 54, such that it audibly informs the user or operator of the warning drive signal.

The classification module 70 receives a control signal from the classification drive controller 55, such that it classifies a semiconductor package having a defective marking into the defective-package storage unit.

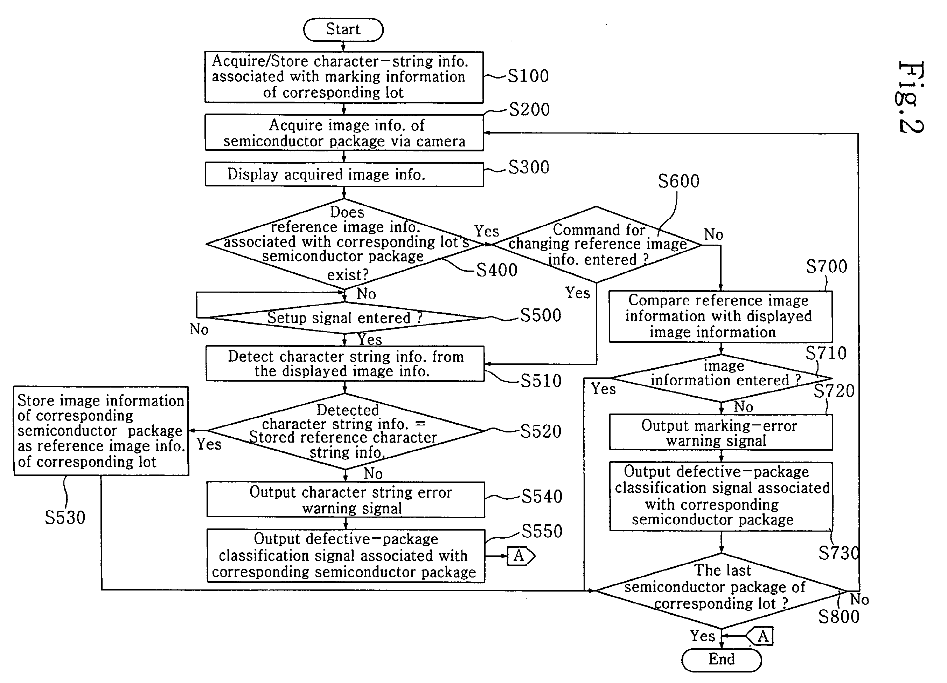

A method for inspecting a marking of a semiconductor package according to the present invention will hereinafter be described with reference to FIG. 2.

FIG. 2 is a flow chart illustrating a method for inspecting a marking of the semiconductor package according to the present invention.

Referring to FIG. 2, in order to establish a reference value of a target object to be inspected, the marking inspection method acquires character string information associated with a character pattern marked on a semiconductor package of a target lot to be inspected, and stores the acquired character string information as reference character string information in the memory 30 at step S100.

The above-mentioned reference character string information may be acquired from the keyboard entered by the user or operator, or may also be acquired from the card reader for reading the lot card including the reference character string information of the target lot.

Thereafter, the above-mentioned marking inspection method captures image information of the character pattern printed on the semiconductor package using the camera module 10, such that the image information of the character pattern is acquired at step S200.

As for the above-mentioned image information, if the light illuminated on the semiconductor package is reflected from the target object to be inspected, and is focused on a lens of the camera module 10, the above-mentioned image information is acquired from the focused light.

The acquired image information is provided to the display 40, such that the user or operator can visually recognize the image information at step S300.

Thereafter, it is determined whether the reference image information of the semiconductor package of a corresponding lot is stored in the memory 30 at step S400.

If it is determined that the reference image information of the corresponding lot is not recorded in the memory 30, and the user or operator enters a setup signal via the input unit 20 at step S500, the above-mentioned marking inspection method detects character string information from the displayed image information of the corresponding semiconductor package using the character-string detector 52 at step S510.

The above-mentioned marking inspection method determines whether the detected character string information is equal to the pre-stored reference character string information at step S520.

If the detected character string information is equal to the pre-stored reference character string information at step S520, the image information of the corresponding semiconductor package is determined to be the reference image information, and the determined reference image information is stored in the memory 30 at step S530.

Otherwise, if the detected character string information is different from the pre-stored reference character string information at step S520, the warning drive controller 54 outputs a control signal to drive the alarm unit 60 and the display 40 at step S540, such that it informs the user or operator of the above warning state. The classification drive controller 55 outputs a defective-package classification signal to the classification module 70 at step S550, such that the corresponding semiconductor package is classified into the defective-package storage unit.

The above-mentioned marking inspection method determines whether a corresponding semiconductor package is indicative of the last object of a corresponding lot after classifying the semiconductor package into the defective-package storage unit. If it is determined that the corresponding semiconductor package is the last object of the corresponding lot, the marking inspection method terminates the marking inspection. Otherwise, if it is determined that the corresponding semiconductor package does not indicate the last object of the corresponding lot, the marking inspection method returns to the above-mentioned image acquisition step S200.

If the reference image information is stored in the memory 30, the marking inspection method sequentially compares semiconductor package image information continuously received from the camera module 10 with the reference image information stored in the memory 30 at step S700, and determines whether the semiconductor package image information is equal to the reference image information at step S710.

If it is determined that the semiconductor package image information is different from the reference image information at step S710 (i.e., if a defective marking occurs), the marking inspection method outputs an alarm signal to the alarm unit 60 and the display 40, such that it visually and audibly informs the user or operator of the defective marking information at step S720. Thereafter, the marking inspection method outputs a defective-package control signal to the classification module 70 to classify the semiconductor package having the defective marking into the defective-package storage unit at step S730.

Upon receiving a command signal for changing the reference information during the comparison time of image information of following semiconductor packages at step S600, the marking inspection method newly acquires character string information from the displayed image information, compares the acquired character string information with the reference character string information stored in the memory 30. Therefore, if the acquired character string information is equal to the reference character string information stored in the memory 30, the marking inspection method updates the image information of the corresponding semiconductor package to the reference image information stored in the memory 30.

After performing the above-mentioned inspection processes, the marking inspection method determines whether a corresponding semiconductor IC is the last inspection object at step S800. If it is determined that the corresponding semiconductor IC is the last inspection object at step S800, the marking inspection method terminates the marking inspection. Otherwise, if it is determined that the corresponding semiconductor IC does not indicate the last inspection object at step S800, the marking inspection method returns to the above-mentioned image acquisition step S200, such that repeats the above-mentioned inspection steps from S200.

As apparent from the above description, the method and apparatus for inspecting the marking of the semiconductor package according to the present invention acquires character string information from only a semiconductor package to be used as reference image information according to an optical character recognition method, determines the presence or absence of a defective marking in the semiconductor package according to the comparison result of the acquired character string information, and compares only image information of other semiconductor packages following the semiconductor package, such that it quickly executes a marking inspection and increases the accuracy of the inspection.

## Claims

1. A method for inspecting a marking of a semiconductor package comprising the steps of:
a) acquiring character string information of a semiconductor package of a target lot to be inspected, and storing the acquired character string information as reference character string information;
b) capturing a character pattern printed on an incoming semiconductor package, and acquiring image information of the incoming semiconductor package;
c) displaying the acquired image information to allow a user or operator to visually recognize the acquired image information;
the method being **characterized by**:
d) detecting character string information from the displayed image information according to a setup signal, comparing the detected character string information with the pre-stored character string information, and determining the displayed semiconductor-package image information to be the new reference image information of a corresponding lot when the detected character string information is equal to the pre-stored character string information thereby updating the reference image information;
wherein the step (d) for determining the new reference image information includes the steps of:
d1) determining the presence or absence of reference image information associated with the target lot to be inspected;
d2) determining whether the setup signal is received;
d3) if the absence of the reference image information is determined, acquiring character string information from the acquired image information according to the setup signal;
d4) determining whether the acquired character string information is equal to the pre-stored reference character string information;
d5) if the acquired character string information is equal to the pre-stored reference character string information, determining image information of a corresponding semiconductor package to be the new reference image information of a corresponding lot; and
d6) if the acquired character string information is different from the pre-stored reference character string information, determining that the corresponding semiconductor package has a defective marking, and classifying the semiconductor package as defective;
the method further comprising:
e) comparing the determined reference image information with image information of sequentially-incoming semiconductor packages, and classifying a corresponding semiconductor package into a defective-package storage unit when the determined reference image information is different from the image information of the sequentially-incoming semiconductor packages.

2. The method according to claim 1, further comprising the step of:
after comparing the detected character string information with the pre-stored character string information at the step (d), if the detected character string information is different from the pre-stored character string information, generating a warning drive signal.

3. The method according to claim 1, further comprising the step of:
after comparing the determined reference image information with the image information of the sequentially-incoming semiconductor packages at step (e), if the determined reference image information is different from the image information of the sequentially-incoming semiconductor packages, generating a warning drive signal.

4. The method according to claim 1, wherein the character string information associated with the semiconductor package of the target lot to be inspected is acquired from a keyboard.

5. The method according to claim 1, wherein the character string information associated with the semiconductor package of the target lot to be inspected is acquired from a reader for reading character strings recorded in a corresponding lot card.

6. The method according to any one of claims 1 to 5, further comprising the steps of:
upon receiving a command signal for changing the determined reference image information, detecting character string information from the displayed image information; and
if the detected character string information is equal to the reference character string information, updating corresponding image information to the pre-stored reference image information, and storing the updated image information.

7. An apparatus for inspecting a marking of a semiconductor package comprising:
a camera module (10) for capturing a character pattern of a semiconductor package via a lens;
an input unit (20) for entering reference character string information of a target lot to be inspected and a variety of operation signals;
a memory (30) for storing the reference character string information received from the input unit (20);
a display (40) for displaying the captured image acquired from the camera module (10);
**characterized by**
a controller (50) for detecting character string information from the displayed image information upon receiving a setup signal from the input unit (20),
determining whether the detected character string information is equal to the pre-stored reference character string information, storing corresponding image information in the memory (30) as reference image information or generating a warning drive signal according to the determined result,
if the reference image information is stored in the memory (30), comparing the reference image information with the image information received from the camera module (10), and
if the reference image information is different from the image information received from the camera module (10), generating the warning drive signal, and generating a defective-package classification control signal for classifying a corresponding semiconductor package into the defective package;
an alarm unit (60) for generating an alarm signal upon receiving the warning drive signal from the controller (50); and
a classification module (70) for classifying the corresponding semiconductor package into a defective-package storage unit upon receiving the defective-package classification control signal from the controller (50);
wherein the controller (50) includes:
a character-string detector (51) for detecting character string information from the displayed image information according to the setup signal;
a character-string processor (52) for comparing the detected character-string information with the reference character string information stored in the memory (30), storing the displayed image information as the reference image information in the memory (30) if the detected character-string information is equal to the reference character string information, and generating a character-string error signal if the detected character-string information is different from the reference character string information;
an image processor (53) for comparing the reference image information stored in the memory (30) with the image information received from the camera module (10), generating an image error signal if the reference image information is different from the received image information, and updating the reference image information stored in the memory (30) upon receiving a signal for changing the reference image information;
a warning drive controller (54) for generating the warning drive signal to the alarm unit (60) or the display (40) according to the character-string error signal or the image error signal; and
a classification drive controller (55) for outputting a defective-package classification control signal capable of classifying a corresponding semiconductor package into the defective semiconductor package to the classification module according to the character-string error signal or the image error signal.

## Patentansprüche

1. Ein Verfahren zum Überprüfen einer Markierung einer Halbleitereinheit umfassend die Schritte:
a) Erwerben von Zeichenfolgeninformation einer Halbleitereinheit eines Zielanteils, der überprüft werden soll und Speichern der erworbenen Zeichenfolgeninformation als Referenzzeichenfolgeninformation;
b) Erfassen eines Zeichenmusters, das auf einer ankommenden Halbleitereinheit aufgedruckt ist und Erwerben von Bildinformation der ankommenden Halbleitereinheit;
c) Darstellen der erworbenen Bildinformation, um einem Nutzer oder Betreiber zu ermöglichen, visuell die erworbene Bildinformation zu erkennen;
wobei das Verfahren **gekennzeichnet ist durch**:
d) Detektieren von Zeichenfolgeninformation der dargestellten Bildinformation entsprechend eines Einrichtungssignals, Vergleichen der detektierten Zeichenfolgeninformation mit der vorgespeicherten Zeichenfolgeninformation und Festlegen der dargestellten Halbleitereinheitbildinformation als die neue Referenzbildinformation eines entsprechenden Anteils, wenn die detektierte Zeichenfolgeninformation gleich ist der vorgespeicherten Zeichenfolgeninformation, **dadurch** Aktualisieren der Referenzbildinformation;
wobei der Schritt d) zum Festlegen der neuen Referenzbildinformation die Schritte umfasst:
d1) Ermitteln der Anwesenheit oder Abwesenheit von Referenzbildinformation, die mit dem Zielanteil assoziiert ist, der überprüft werden soll;
d2) Ermitteln, ob das Einrichtungssignal empfangen wurde;
d3) wenn die Abwesenheit der Referenzbildinformation ermittelt wurde, Erwerben von Zeichenfolgeninformation von der erworbenen Bildinformation entsprechend des Einrichtungssignals;
d4) Ermitteln, ob die erworbene Zeichenfolgeninformation gleich ist der vorgespeicherten Referenzeichenfolgeninformation;
d5) wenn die erworbene Zeichenfolgeninformation gleich ist der vorgespeicherten Referenzzeichenfolgeninformation, Festlegen von Bildinformation einer entsprechenden Halbleitereinheit als die neue Referenzbildinformation eines entsprechenden Anteils und
d6) wenn die erworbene Zeichenfolgeninformation verschieden ist von der vorgespeicherten Referenzzeichenfolgeninformation, Festlegen, dass die entsprechende Halbleitereinheit eine defekte Markierung hat und Klassifizieren der Halbleitereinheit als defekt;
wobei das Verfahren weiter umfasst:
e) Vergleichen der ermittelten Referenzbildinformation mit Bildinformation von sequentiell ankommenden Halbleitereinheiten und Klassifizieren einer entsprechenden Halbleitereinheit in eine Speichereinheit für defekte Einheiten, wenn die ermittelte Referenzbildinformation verschieden ist von der Bildinformation der sequentiell ankommenden Halbleitereinheiten.

2. Das Verfahren gemäß Anspruch 1, weiter umfassend den Schritt:
nach Vergleichen der detektierten Zeichenfolgeninformation mit der vorgespeicherten Zeichenfolgeninformation in Schritt d), Erzeugen eines Warnsignals, wenn die detektierte Zeichenfolgeninformation verschieden ist von der vorgespeicherten Zeichenfolgeninformation.

3. Das Verfahren gemäß Anspruch 1, weiter umfassend den Schritt:
nach Vergleichen der ermittelten Referenzbildinformation mit der Bildinformation der sequentiell ankommenden Halbleitereinheiten in Schritt e), Erzeugen eines Warnsignals, wenn die ermittelte Referenzbildinformation verschieden ist von der Bildinformation der sequentiell ankommenden Halbleitereinheiten.

4. Das Verfahren gemäß Anspruch 1, wobei die Zeichenfolgeninformation, die mit der Halbleitereinheit des Zielanteils assoziiert ist, der überprüft werden soll, von einer Tastatur erhalten wird.

5. Das Verfahren gemäß Anspruch 1, wobei die Zeichenfolgeninformation, die mit der Halbleitereinheit des Zielanteils assoziiert ist, der überprüft werden soll, von einem Leser erhalten wird, der Zeichenfolgen liest, die in einer entsprechenden Anteilskarte eingetragen sind.

6. Das Verfahren gemäß einem der Ansprüche 1 bis 5, weiter umfassend die Schritte:
bei Empfang eines Kommandosignals zum Ändern der ermittelten Referenzbildinformation, Ermitteln von Zeichenfolgeninformation der dargestellten Bildinformation und
wenn die ermittelte Zeichenfolgeninformation gleich ist der Referenzzeichenfolgeninformation, Aktualisieren der vorgespeicherten Referenzzeichenfolgeninformation mit der entsprechenden Bildinformation und Speichern der aktualisierten Bildinformation.

7. Eine Vorrichtung zum Überprüfen einer Markierung einer Halbleitereinheit umfassend:
ein Kameramodul (10) zum Erfassen eines Zeichenmusters einer Halbleitereinheit mittels einer Linse;
eine Eingabeeinheit (20) zum Eingeben von Referenzzeichenfolgeninformation eines Zielanteils, der überprüft werden soll und einer Vielzahl von Betriebssignalen;
einen Speicher (30) zum Speichern der von der Eingabeeinheit (20) empfangenen Referenzzeichenfolgeninformation;
einen Bildschirm (40) zum Darstellen des von dem Kameramodul (10) erfassten Bildes;
**gekennzeichnet durch**
einen Kontroller (50) zum Detektieren von Zeichenfolgeninformation der dargestellten Bildinformation bei Erhalt eines Einrichtungssignals von der Eingabeeinheit (20),
Ermitteln, ob die detektierte Zeichenfolgeninformation gleich ist der vorgespeicherten Referenzzeichenfolgeninformation, Speichern entsprechender Bildinformation in dem Speicher (30) als Referenzbildinformation oder Erzeugen eines Warnsignals entsprechend des ermittelten Ergebnisses,
wenn die Referenzbildinformation in dem Speicher (30) gespeichert ist, Vergleichen der Referenzbildinformation mit der von dem Kameramodul (10) erhaltenen Bildinformation, und
wenn die Referenzbildinformation verschieden ist von der von dem Kameramodul (10) erhaltenen Bildinformation, Erzeugen eines Warnsignals und Erzeugen eines Klassifizierungskontrollsignals für defekte Einheiten zum Klassifizieren einet entsprechenden Halbleitereinheit als defekte Einheit;
eine Alarmeinheit (60) zum Erzeugen eines Alarmsignals bei Empfang des Warnsignals von dem Kontroller (50); und
ein Klassifizierungsmodul (70) zum Klassifizieren der entsprechenden Halbleitereinheit in eine Speichereinheit für defekte Einheiten bei Empfang des Klassifizierungskontrollsignals für defekte Einheiten von dem Kontroller (50);
wobei der Kontroller (50) umfasst:
einen Zeichenfolgendetektor (51) zum Detektieren von Zeichenfolgeninformation der dargestellten Bildinformation gemäß dem Einrichtungssignal;
einen Zeichenfolgenprozessor (52) zum Vergleichen der detektierten Zeichenfolgeninformation mit der in dem Speicher (30) gespeicherten Referenzzeichenfolgeninformation, Speichern der dargestellten Bildinformation als die Referenzbildinformation in dem Speicher (30), wenn die detektierte Zeichenfolgeninformation gleich ist der Referenzzeichenfolgeninformation, und Erzeugen eines Zeichenfolgenfehlersignals, wenn die detektierte Zeichenfolgeninformation verschieden ist von der Referenzzeichenfolgeninformation;
einen Bildprozessor (53) zum Vergleichen der in dem Speicher (30) gespeicherten Referenzbildinformation mit der von dem Kameramodul (10) empfangenen Bildinformation, Erzeugen eines Bildfehlersignals, wenn die Referenzbildinformation verschieden ist von der empfangenen Bildinformation und Aktualisieren der in dem Speicher (30) gespeicherten Referenzbildinformation bei Empfang eines Signals zum Ändern der Referenzbildinformation;
einen Warnkontroller (54) zum Erzeugen des Warnsignals für die Alarmeinheit (60) oder das Display (40) entsprechend des Zeichenfolgenfehlersignals oder des Bildfehlersignals; und
einen Klassifikationskontroller (55) zum Ausgeben eines Klassifizierungskontrollsignals für defekte Einheiten, das fähig ist zum Klassifizierung einer entsprechenden Halbleitereinheit als das defekte Halbleitereinheit in dem Klassifizierungsmodul entsprechend des Zeichenfolgenfehlersignals oder des Bildfehlersignals.

## Revendications

1. Procédé d'inspection du marquage d'un boîtier de semiconducteur comprenant les étapes consistant à :
a) acquérir des informations de chaîne de caractères d'un boîtier de semiconducteur d'un lot cible destiné à être inspecté, et enregistrer les informations de chaîne de caractères acquises en tant qu'informations de chaîne de caractères de référence ;
b) saisir un motif de caractères imprimé sur un boîtier de semiconducteur entrant et acquérir des informations d'image sur le boîtier de semiconducteur entrant ;
c) afficher les informations d'image acquises pour permettre à un utilisateur ou à un opérateur de reconnaître visuellement les informations d'image acquises ;
le procédé étant **caractérisé par** :
d) une détection d'informations de chaîne de caractères d'après les informations d'image affichées conformément à un signal de réglage, une comparaison des informations de chaîne de caractères détectées avec les informations de chaîne de caractères préenregistrées, et une détermination des informations d'image de boîtier de semiconducteur affichées pour devenir les nouvelles informations d'image de référence d'un lot correspondant, lorsque les informations de chaîne de caractères détectées sont identiques aux informations de chaîne de caractères préenregistrées, de façon à mettre à jour les informations d'image de référence ;
dans lequel l'étape (d) de détermination les nouvelles informations d'image de référence comporte les étapes consistant à :
d1) déterminer la présence ou l'absence d'informations d'image de référence associées au lot cible à inspecter ;
d2) déterminer si le signal de réglage est reçu ;
d3) si l'absence des informations d'image de référence est déterminée, acquérir des informations de chaîne de caractères d'après les informations d'image acquises conformément au signal de réglage ;
d4) déterminer si les informations de chaîne de caractères acquises sont identiques aux informations de chaîne de caractères de référence préenregistrées ;
d5) si les informations de chaîne de caractères acquises sont identiques aux informations de chaîne de caractères de référence préenregistrées, déterminer les informations d'image d'un boîtier de semiconducteur correspondant comme étant les nouvelles informations d'image de référence d'un lot correspondant ; et
d6) si les informations de chaîne de caractères acquises sont différentes des informations de chaîne de caractères de référence préenregistrées, déterminer que le boîtier de semiconducteur correspondant présente un marquage défectueux, et classer le boîtier de semiconducteur comme défectueux ;
le procédé comprenant en outre :
e) une comparaison des informations d'image de référence déterminées avec des informations d'image de boîtiers de semiconducteur qui arrivent en séquence, et une classification d'un boîtier de semiconducteur correspondant dans une unité de mémorisation de boîtier défectueux lorsque les informations d'image de référence déterminées sont différentes des informations d'image des boîtiers de semiconducteur qui arrivent en séquences.

2. Procédé selon la revendication 1, comprenant en outre l'étape consistant à :
après comparaison des informations de chaîne de caractères détectées avec les informations de chaîne de caractères préenregistrées à l'étape (d), si les informations de chaîne de caractères détectées sont différentes des informations de chaîne de caractères préenregistrées, générer un signal de commande d'avertissement.

3. Procédé selon la revendication 1, comprenant en outre l'étape consistant à :
après comparaison des informations d'image de référence déterminées avec les informations d'image des boîtiers de semiconducteur qui arrivent en séquence à l'étape (e), si les informations d'image de référence déterminées sont différentes des informations d'image des boîtiers de semiconducteur qui arrivent en séquence, générer un signal de commande d'avertissement.

4. Procédé selon la revendication 1, dans lequel les informations de chaîne de caractères associées au boîtier de semiconducteur du lot cible à inspecter sont acquises à partir d'un clavier.

5. Procédé selon la revendication 1, dans lequel les informations de chaîne de caractères associées au boîtier de semiconducteur du lot cible à inspecter sont acquises à partir d'un lecteur destiné à lire des chaînes de caractères enregistrées sur une carte de lot correspondante.

6. Procédé selon l'une quelconque des revendications 1 à 5, comprenant en outre les étapes consistant à :
lors d'une réception d'un signal de commande pour modifier les informations d'image de référence déterminées, détecter les informations de chaîne de caractères d'après les informations d'image affichées ;
et
si les informations de chaîne de caractères détectées sont identiques aux informations de chaîne de caractères de référence, mettre à jour les informations d'image correspondantes en informations d'image de référence préenregistrées et enregistrer les informations d'image mises à jour.

7. Appareil d'inspection du marquage d'un boîtier de semiconducteur comprenant :
un module de prise de vue (10) pour saisir un motif de caractères d'un boîtier de semiconducteur par l'intermédiaire d'une lentille ;
une unité d'entrée (20) pour entrer des informations de chaîne de caractères de référence d'un lot cible à inspecter et une diversité de signaux d'exploitation ;
une mémoire (30) pour enregistrer les informations de chaîne de caractères de référence reçues depuis l'unité d'entrée (20) ;
un dispositif d'affichage (40) pour afficher l'image saisie acquise par le module de prise de vue (10) ;
**caractérisé par**
un contrôleur (50) pour détecter des informations de chaîne de caractères d'après les informations d'image
affichée lors d'une réception d'un signal de réglage provenant de l'unité d'entrée (20),
déterminer si les informations de chaîne de caractères détectées sont identiques aux informations de chaîne de caractères de référence préenregistrées, enregistrer les informations d'image correspondantes dans la mémoire (30) en tant qu'informations d'image de référence ou générer un signal de commande d'avertissement en fonction du résultat déterminé,
si les informations d'image de référence sont enregistrées dans la mémoire (30), comparer les informations d'image de référence avec les informations d'images reçues depuis le module de prise de vue (10), et
si les informations d'image de référence sont différentes des informations d'images reçues depuis le module de prise de vue (10), générer le signal de commande d'avertissement, et générer un signal de commande de classification de boîtier défectueux pour classer un boîtier de semiconducteur correspondant en boîtier défectueux ;
une unité d'alarme (60) pour générer un signal d'alarme lors de la réception du signal de commande d'avertissement provenant du contrôleur (50) ; et
un module de classification (70) pour classer le boîtier de semiconducteur correspondant dans une unité de mémorisation de boîtier défectueux lors d'une réception du signal de commande de classification de boîtier défectueux provenant du contrôleur (50) ;
dans lequel le contrôleur (50) comporte :
un détecteur de chaîne de caractères (51) pour détecter des informations de chaîne de caractères d'après les informations d'image affichée en fonction du signal de réglage ;
un processeur de chaîne de caractères (52) pour comparer les informations de chaîne de caractères détectées avec les informations de chaîne de caractères de référence enregistrées dans la mémoire (30), enregistrer les informations d'image affichée en tant qu'informations d'image de référence dans la mémoire (30) si les informations de chaîne de caractères détectées sont identiques aux informations de chaîne de caractères de référence et générer un signal d'erreur de chaîne de caractères si les informations de chaîne de caractères détectées sont différentes des informations de chaîne de caractères de référence ;
un processeur d'image (53) pour comparer les informations d'image de référence enregistrées dans la mémoire (30) avec les informations d'image reçues depuis le module de prise de vue (10), générer un signal d'erreur d'image si les informations d'image de référence sont différentes des informations d'image reçues et mettre à jour les informations d'image de référence enregistrées dans la mémoire (30) lors de la réception d'un signal pour modifier les informations d'image de référence ;
un contrôleur de commande d'avertissement (54) pour générer le signal de commande d'avertissement vers l'unité d'alarme (60) ou le dispositif d'affichage (40) en fonction du signal d'erreur de chaîne de caractères ou du signal d'erreur d'image ; et
un contrôleur de commande de classification (55) pour fournir en sortie un signal de commande de classification de boîtier défectueux capable de classer un boîtier de semiconducteur correspondant en boîtier de semiconducteur défectueux vers le module de classification en fonction du signal d'erreur de chaîne de caractères ou du signal d'erreur d'image.
